(19) Europäisches Patentamt
European Patent Office
Office européen des brevets

(11) **EP 0 489 945 B1**

(12) **EUROPÄISCHE PATENTSCHRIFT**

(45) Veröffentlichungstag und Bekanntmachung des Hinweises auf die Patenterteilung:
**29.01.2003  Patentblatt 2003/05**

(51) Int Cl.⁷: **H03K 17/732**

(21) Anmeldenummer: **90123659.6**

(22) Anmeldetag: **08.12.1990**

(54) **Schaltanordnung für einen HF-GTO**

Switching arrangement for an HF-GTO

Dispositif de commutation pour un GTO-HF

(84) Benannte Vertragsstaaten:
**BE CH DE FR GB IT LI NL**

(43) Veröffentlichungstag der Anmeldung:
**17.06.1992  Patentblatt 1992/25**

(60) Teilanmeldung:
**02011727.1 / 1 248 368**

(73) Patentinhaber: **ABB Schweiz AG**
**5400 Baden (CH)**

(72) Erfinder: **Grüning, Horst, Dr.**
**CH-5430 Wettingen (CH)**

(74) Vertreter: **ABB Patent Attorneys**
**c/o ABB Schweiz AG**
**Brown Boveri Strasse 6**
**5400 Baden (CH)**

(56) Entgegenhaltungen:
**EP-A- 0 228 226          EP-A- 0 320 784**
**FR-A- 2 580 127**

- **CONFERENCE RECORD INDUSTRY APPLICATIONS SOCIETY, IEEE-IAS-1985 ANNUAL MEETING, Toronto, 6. - 11. Oktober 1985, Seitens 955-959; A.P. CONNOLLY et al.: "Application of GTO thyristor modules"**
- **BROWN BOVERI REVIEW, Band 73, Nr. 9, September 1986, Seiten 519-525, Baden, CH; D. EISELE et al.: "Two new GTO modules for drive applications"**

## Beschreibung

### Technisches Gebiet

Die Erfindung betrifft eine Schaltanordnung für einen HF-GTO hoher Leistung nach dem Oberbegriff des ersten Anspruchs.

Stand der Technik

Heute sind auf dem Markt von gut 10 Halbleiterherstellern etwa 190 GTO-Typen erhältlich. In der Anwendung teilen sie sich im wesentlichen auf drei wichtige Einsatzgebiete auf, nämlich Traktion (z.B. Lokomotiven), USV (unterbrechungsfreie Stromversorgung) und industrielle Antriebe. Diese weite Verbreitung hat stattgefunden, obwohl der GTO für den Anwender z.B. schaltungstechnisch mit einigen Problemen behaftet ist. Einer Verbesserung des GTOs resp. dessen Beschaltung kommt deshalb eine enorme wirtschaftliche Bedeutung zu.

Der Anwender sieht sich im Zusammenhang mit dem GTO insbesondere mit folgenden Problemkreisen konfrontiert:

- Aufwand in der Ansteuerung;
- Ausschaltausfälle;
- Einhalten der Spike-Spannung;
- Schaltverluste im GTO und in der Beschaltung;
- Kühlung.

Abschaltbare Thyristoren (GTO) müssen bislang mit erheblichen Beschaltungsnetzwerken (Snubbern) betrieben werden. Neben Mehrgewicht, erhöhtem Volumen und beträchtlichen Verlusten zieht dies insbesondere auch zusätzliche Entwicklungs- und Herstellungskosten nach sich. Auch die Entwicklung von Steuersoftware ist durch die von den Snubbern bestimmte, komplizierte Betriebsweise deutlich aufwendiger. Man ist deshalb bestrebt, die Snubber zu verkleinern (kleinere Induktivitäten und kleinere Kapazitäten) und zu vereinfachen. Eine wichtige Rolle spielen insbesondere Streuinduktivität und Snubberdiode. Zur Verringerung von Ueberspannungen muss ein erheblicher konstruktiver Aufwand betrieben werden. Es sind in jüngerer Zeit auch ganz spezielle Dioden für diese Anwendungen entwickelt worden.

Der Grund für die benötigten Snubber liegt anerkanntermassen im nichthomogenen Ein- und Abschalten der GTOs: Lange Studien mit Infrarot-, Wärme- und Induktionsmessungen haben immer wieder diesen Tatbestand hervorgehoben. Man hat deshalb die Anstrengungen auf die Herstellung von möglichst homogenen Bauelementen (insbesondere bezüglich der Dotierung) gerichtet. Trotz markanten Verbesserungen der Dotierungshomogenität konnten die Snubber aber nicht wesentlich vereinfacht oder verkleinert werden.

Das erklärte Wunschziel von Anwendern und Herstellern ist der HF-GTO. Dieser soll sich unter anderem auszeichnen durch einen deutlich geringeren Beschaltungsaufwand, durch geringe Ansteuerleistung und geringe Ausschaltausfälle. Bis jetzt ist aber nicht bekannt, wie ein solches Bauelement aussehen soll und wie es betrieben werden soll. Konventionelle Ansteuerverfahren sind z.B. aus dem Artikel "Two New GTO Modules for Drive Applications", Brown Boveri Review, Band 73, Nr. 9, September 1986, Seiten 519-525, bekannt. Die Gatestromsteilheit beträgt je nach Typ lediglich 10 A/µs oder 30 A/µs bei abschaltbaren Strömen von 90 A bzw. 160 A. Demzufolge ist auch ein konventionelles, aufwendiges Schutzbeschaltungsnetzwerk sogar für den dargestellten GTO kleinerer Leistung notwendig.

Der Artikel "Application of GTO Thyristor Modules" im Conference Record Industry Applications Society, IEEE-IAS-1985 Annual Meeting, 1985, Seiten 955-959 beschreibt ein ähnliches Verfahren und vergleichbare Schaltungsanordnungen für GTOs kleinerer Leistung, mit denen die gewünschten Eigenschaften aber noch nicht erreicht werden können.

### Darstellung der Erfindung

Aufgabe der Erfindung ist es, eine Schaltungsanordnung und eine dafür geeignete Schutzschaltung anzugeben, die die beim Stand der Technik vorhandenen Probleme beseitigt. Insbesondere soll der angestrebte HF-GTO hoher Leistung möglichst mit den bekannten GTO-Gehäusen realisiert werden. Diese Aufgabe wird durch die Merkmale der unabhängigen Ansprüche gelöst. Kern der Erfindung ist es, dass beim Abschalten ein Maximalwert $I_{Gpeak}$ des Gatestromes $I_G$ so gross gewählt wird, dass eine Abschaltverstärkung $I_A/I_{Gpeak}$ erreicht wird, die kleiner als 3, insbesondere kleiner oder gleich 2 ist. Ausserdem soll die Anstiegsgeschwindigkeit $dI_G/dt$ dieses Gatestromes $I_G$ so gross gewählt werden, dass innerhalb von einer 1 µs ein Gatestrom $I_G$ in der Grösse des maximal abschaltbaren Anodenstromes $I_{A,max}$ aufgebaut wird, und der Gatestrom $I_G$ soll, nach Auftreten eines Tailstromes $I_{Tail,}$ mindestens doppelt so gross gewählt werden wie der Tailstrom $I_{Tail}$.

Die erfindungsgemässe Schaltungsanordnung umfasst eine erste Kapazität $C_{R1}$, die über einen Schalter zwischen Gate und Kathode des GTOs geschaltet ist und die durch Entladen den schnell ansteigenden ersten Gatestrom $I_G$ zum Abschalten des GTOs erzeugt, und eine zweite Kapazität $C_{E1}$, die über eine erste Diode $D_1$ parallel zur ersten Kapazität $C_{R1}$ angeordnet ist und die durch Entladen den Gatestrom $I_G$ nach Auftreten des Tailstromes erzeugt.

Eine Schutzbeschaltung für einen derart angesteuerten GTO umfasst unmittelbar parallel zum GTO zwischen Anode und Kathode eine induktivitätsarme Kapazität $C_p$, die den Anodenspannungsanstieg $dV_A/dt$ mindestens nach Erreichen einer Anodenspannung von

$V_A$=400V so begrenzt, dass der Anodenstrom $I_A$ in der Folge kleiner als der Gatestrom $I_G$ wird.

Gemäss der Erfindung sollten also zur Realisierung des HF-GTOs die folgenden Prinzipien schaltungstechnisch umgesetzt werden:

- Die Gateansteuerung zum Abschalten des GTO-Bauelements ist so ausgelegt, dass sie eine Abschaltverstärkung $I_A/I_{G,peak}$ realisiert, die deutlich kleiner als 3, insbesondere kleiner oder gleich 2 ist und dass ein Anodenspannungsanstieg $dV_A/dt$ von mindestens 1 kV/μs resultiert.

- Der Gatestrom $I_G$ ist während des gesamten Abschaltvorgangs so gross, dass ein Anodenspannungsanstieg von mindestens 1 kV/μs resultiert und dass der Kathodenstrom $I_K$ unter Berücksichtigung des Kirchhoff' schen Gesetzes $I_G + I_K = I_A$, wobei $I_A$ den Anodenstrom bezeichnet, immer kleiner oder gleich null ist.

- Der Gatestram $I_G$ ist beim Abschalten mindestens doppelt so gross, wie der auftretende Tailstrom $I_{Tail}$.

- Der Gatestrom $I_G$ hat eine Anstiegsgeschwindigkeit $dI_G/dt$ hat, die ausreicht, um innerhalb 1 μs einen Gatestrom in der Grösse des maximal abschaltbaren Anodenstroms $I_{A,max}$ aufzubauen.

Einzelne oder mehrere der vier Bedingungen können vorteilhaft mit der im Folgenden beschriebenen Schaltungstechnik erfüllt werden.

Gemäss einer vorteilhaften Ausführungsform der Erfindung ist die Gate-Unit möglichst niederinduktiv an das Gate des GTO-Bauelements angeschlossen, so dass eine Gatekreisinduktivität von vorzugsweise weniger als 50 nH vorhanden ist. Als niederinduktive Verbindung eignet sich insbesondere ein Flachbandleiter wie er z.B. in der veröffentlichten Patentanmeldung EP-0,381,849 A1 beschrieben ist. Weiterhin sollten Mittel (z.B. mindestens eine Kapazität $C_{R1}$ oder ein Pulsformnetzwerk) vorgesehen sein, die einen schnell ansteigenden und mindestens bis zum Abklingen des Tailstroms anhaltenden Gatestrom erzeugen. Der Gatestrom sollte jedenfalls grösser als der Tailstrom sein.

Vorzugsweise umfassen die genannten Mittel eine Kapazität $C_{R1}$, die vor dem Abschalten des GTO-Bauelementes eine Spannung von mindestens 100 V hat. Auf diese Weise lässt sich trotz der vorhandenen Gatekreisinduktivität der gewünschte Gatestrom hinreichend schnell aufbauen. Ausserdem empfiehlt es sich, mindestens eine weitere Kapazität $C_{E1}$ vorzusehen, die nach dem Entladen der Kapazität $C_{R1}$ einen länger andauernden Haltestrom aus dem Gate zieht.

Um die beschriebenen Bedingungen mit geringem Aufwand zu erfüllen, kann vorzugsweise unmittelbar parallel zum GTO-Bauelement zwischen Anode und Kathode eine Kapazität $C_p$ vorgesehen sein, die den Anodenspannungsanstieg $dV_A/dt$ bei hohen Spannungen begrenzt und einen Teil der Energie aus einer an die Anode angeschlossenen Induktivität $L_A$ (di/dt-Drossel) übernimmt. Zumindest nach Erreichen einer Anodenspannung $V_A$ = 400 V sollte der Anstieg so begrenzt sein, dass der Anodenstrom in der Folge kleiner als der Gatestrom wird.

Damit das GTO-Bauelement durch die parallele Kapazität $C_p$ einerseits beim Einschalten nicht zu stark belastet und andererseits beim Ausschalten dennoch genügend unterstützt wird, sollte sie in bezug auf den Anodenstrom $I_A$ gemäss folgender Regel bemessen sein:

$$3 \text{ kV/μs} \leq \frac{I_A}{C_p} \leq 10 \text{ kV/μs}$$

Im allgemeinen wird man zusätzlich zu dieser parallelen Kapazität $C_p$ noch einen herkömmlichen Snubber (mit einer Kapazität $C_s$) benötigen, um die durch $L_A$ hervorgerufenen Ueberspannungen im üblichen Rahmen zu halten.

Vorzugsweise können Mittel zum Fernhalten der in der Induktivität $L_A$ gespeicherten Energie von der parallelen Kapazität $C_p$ vorgesehen werden, die in der Art eines Freilaufs wirken und infolgedessen besonders niedrige Ueberspannungen und gleichzeitige Energierückführung gestatten.

Durch hartes Einschalten kann die Ueberlastungsgefahr des GTOs aufgrund der parallelen Kapazität $C_p$ gering gehalten werden. Die Beschaltungen zum Ein- und Ausschalten sind vorzugweise schaltungstechnisch analog ausgeführt. Die Anstiegsgeschwindigkeit $dI_G/dt$ sollte grösser als 200 A/μs sein.

Um ein sauberes Abschalten zu erreichen, sind vorzugsweise Mittel zur Begrenzung der Geschwindigkeit des Anodenspannungsanstiegs $dV_A/dt$ während des Abschaltvorganges vorzusehen.

Die Erfindung richtet sich primär auf Schaltungen, bei denen die Mittel zum Erzeugen des Gatestroms (Gate-Unit) ausserhalb des Gehäuses das Halbleiterbauelements angeordnet sind. Dies trifft auf die meisten konventionellen Bauelemente der bevorzugten Leistungsklasse ab 1.5 kV und ab 1 kA zu. Der Begriff "einrastendes Halbleiterbauelement" umfasst 2-Schichtbauelemente vom Typ eines FCThs oder eines SIThs ebenso wie 4-Schichtbauelemente vom Typ eines GTOs oder eines FS-GTOs.

Aus der Gesamtheit der abhängigen Patentansprüchen ergeben sich weitere vorteilhafte Ausführungsformen.

## Kurze Beschreibung der Zeichnungen

Nachfolgend soll die Erfindung anhand von Ausführungsbeispielen und im Zusammenhang mit den Zeichnungen näher erläutert werden.

Es zeigen:

Fig. 1 ein Schaltschema einer GTO-Beschaltung gemäss dem Stand der Technik;

Fig. 2 eine graphische Darstellung von Anodenspannung $V_A$, Anodenstrom $I_A$ und Gatestrom $I_G$ beim Abschalten unter zu hoher Last gemäss dem Stand der Technik;

Fig. 3 eine Gatebeschaltung zum Abschalten des GTOs;

Fig. 4 einen Snubber gemäss der Erfindung; und

Fig. 5 eine Gatebeschaltung zum Einschalten des GTOs.

Die in den Zeichnungen verwendeten Bezugszeichen und deren Bedeutung sind in der Bezeichnungsliste zusammenfassend aufgelistet. Grundsätzlich sind in den Figuren gleiche Teile mit gleichen Bezugszeichen versehen.

**Wege zur Ausführung der Erfindung**

Um die Erfindung in ihrer Gesamtheit besser hervortreten zu lassen, soll zunächst auf die Probleme und die Fehler bei der bekannten Snubberbeschaltung eingegangen werden. Wenn man nämlich die Ursachen für den Ausschaltausfall erst einmal in aller Schärfe erkannt hat, dann stehen der schaltungstechnischen Umsetzung der Schlussfolgerungen keine unüberwindbaren Hindernisse mehr im Weg.

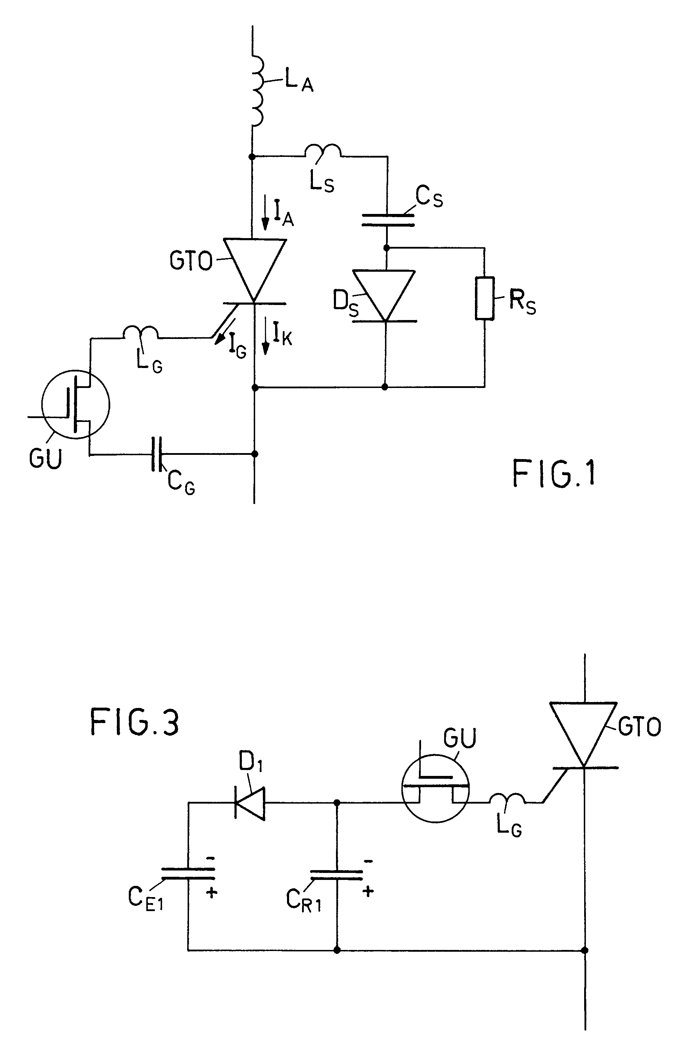

Fig. 1 zeigt ein Schaltschema einer herkömmlichen GTO-Beschaltung. Im Zentrum steht das GTO-Bauelement. An seiner Anode hängt eine Drossel $L_A$ zur dI/dt-Begrenzung. Der Snubber umfasst eine Induktivität $L_s$, eine Kapazität $C_s$, einen Widerstand $R_s$ und eine Diode $D_s$. Zum Ausschalten des GTO-Bauelements ist eine Gate-Unit GU vorgesehen, die eine Kapazität $C_G$ in das Gate entlädt. Der Gatestrom wird dabei durch eine Induktivität $L_G$ verzögert.

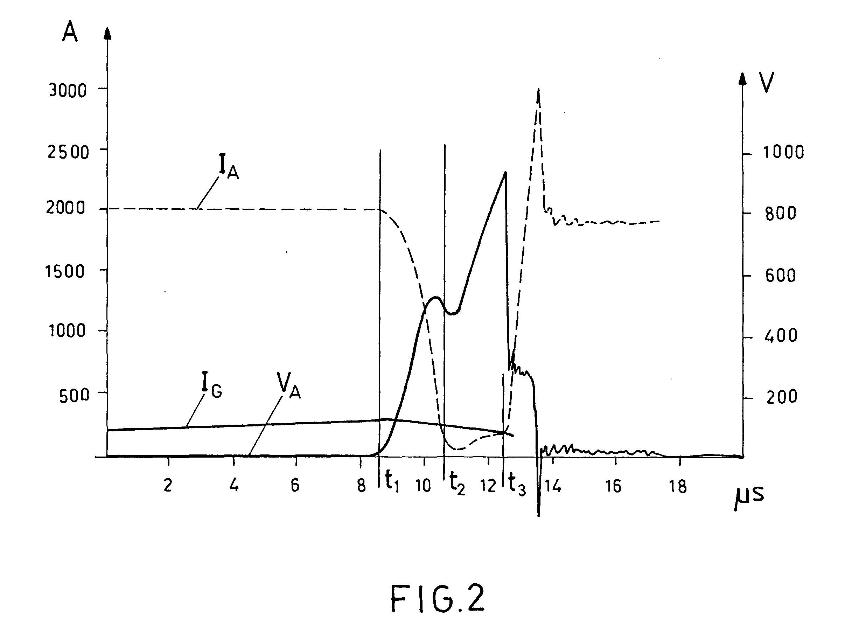

Fig. 2 zeigt Anodenspannung $V_A$, Anodenstrom $I_A$ und Gatestrom $I_G$ beim fehlerhaften Abschalten in einer bekannten GTO-Beschaltung (Fig. 1). Der nicht eingezeichnete Kathodenstrom $I_K$ lässt sich mit der Kirchhoff'schen Regel ermitteln ($I_G + I_K = I_A$). Auf der Abszisse ist die Zeit in µs aufgetragen (der Zeitnullpunkt ist hier bedeutungslos). Auf der linken Seite ist der Strom in Ampere und auf der rechten Seite der Darstellung die Spannung in Volt aufgetragen.

Zum Abschalten des GTOs wird dem Gate ein Gatestrom $I_G$ mit einer Anstiegsgeschwindigkeit $dI_G/dt$ von typischerweise 10 A/µs aufgezwungen. Ueber eine längere Zeit von 6 bis 15 µs (je nach Grösse des Anodenstroms) fliesst der Anodenstrom aber nach wie vor im wesentlichen unverändert weiter. Zu einem bestimmten Zeitpunkt $t_1$ erreicht der Gatestrom $I_G$ die durch die Abschaltverstärkung definierte Schwelle, die den GTO zum Abschalten bringt. Um den Gatestrom und damit die Ansteuerleistung möglichst klein zu halten, werden heute möglichst hohe Abschaltverstärkungen $I_A/I_{G,peak}$, wobei $I_{G,peak}$ den maximalen Gatestrom bezeichnet, angestrebt. Typischerweise liegen diese Verhältnisse in einem Bereich zwischen 3 und 5.

Wenn nun die durch die Abschaltverstärkung definierte Schwelle erreicht ist, beginnt die Anodenspannung $V_A$ anzusteigen. Gleichzeitig fällt der Anodenstrom $I_A$ ab. Aufgrund des Kirchhoff'schen Gesetzes muss der Kathodenstrom $I_K$ aber grösser null sein, bis der Anodenstrom $I_A$ auf das Niveau des Gatestroms $I_G$ abgefallen ist (Zeitpunkt $t_2$ in Fig. 2). Das Bauelement befindet sich in diesem Zeitabschnitt (d.h. von $t_1$ bis $t_2$) in einem instabilen und somit gefährlichen Zustand: Der GTO, der als Schalter und nicht als Regler ausgebildet ist (man denke an das bekannte Ersatzschaltbild zweier gekoppelter Transistoren), muss auf diese Beanspruchung zwangsläufig mit Strominhomogenitäten reagieren.

Mit anderen Worten: Weil das Bauelement bei langsamem Gatestromanstieg (welcher durch die Kapazität $L_G$ kontrolliert wird) so "gutmütig" ist, bei entsprechend kleinem Gatestrom bereits abzuschalten (entsprechend der stets geforderten hohen Abschaltverstärkung), kann es dann, wenn es Spannung aufnehmen muss, nicht den Kathodenstrom zu Null gehen lassen (aufgrund des Kirchhoff'schen Gesetzes), sondern muss in den es selbst gefährdenden Instabilitätsbereich laufen.

Diese erste Gefahrenzone übersteht der GTO aber meistens. Dies aber nicht zuletzt aufgrund der Tatsache, dass die Spike-Spannung (d.h. die Spannungsspitze von ca. 500 V kurz vor $t_2$, die hervorgerufen wird durch den Snubber) mit allen Mitteln klein gehalten wird. Dass es sich bei der Spike-Spannung um einen kritischen Parameter handelt, hat man nämlich erkannt.

Nach $t_2$ ist der Anodenstrom $I_A$ kleiner als der Gatestrom $I_G$ und der Kathodenstrom $I_K$ infolgedessen negativ. Der GTO befindet sich wieder in einem stabilen Zustand. Die Anodenspannung $V_A$ steigt mittlerweile weiter an. Der Anodenstrom $I_A$ durchläuft ein Minimum bevor der Tailstrom einsetzt. Sobald der Tailstrom den Gatestrom $I_G$ aber schneidet (Zeitpunkt $t_3$), kommt das Bauelement in die zweite, diesmal aber mit Sicherheit tödliche Gefahrenzone.

Aufgrund des positiven Kathodenstroms $I_K$ steuern zumindest einzelne Kathodenemitter auf (sie wollen den GTO einschalten). Der Anodenstrom $I_A$ beginnt extrem steil anzusteigen, da der Strom aus dem Snubber (die Diode ist überschwemmt, die Induktivität $L_S$ ist ziemlich klein) und nicht über die di/dt-Drossel $L_A$ bezogen wird (Fig. 1). Es handelt sich also um ein Einschalten des GTOs jenseits von jeder zulässigen Spezifikation (keine di/dt-Begrenzung, undefinierte Anstiegsgeschwindigkeit des Gatestroms, überschwemmtes Bauelement im Tailstrombereich). Die Tatsache, dass die Anodenspannung unmittelbar nach $t_3$ nicht sogleich auf null abfällt, sondern nur bis auf ca. 300 V, deutet darauf hin, dass nur einzelne Zellen einschalten (Strominhomogenität). Solche Belastungen überlebt der GTO aber nicht, er brennt durch.

Untersuchungen haben ergeben, dass sich bei kleinen Anodenspannungen (z.B. 50 V) fast beliebig grosse Ströme im GTO abschalten lassen. Je höher aber die anliegende Spannung ist, desto gefährlicher wird es für den GTO gemäss dem Stand der Technik Kathodenstrom führen zu müssen. Ab etwa 400 V darf dieser Zustand nur noch ganz schwach und kurz sein - macht der GTO nicht mehr mit. Dieser Zusammenhang zwischen abschaltbarem Strom und Anodenspannung beruht auf dem Auftreten von dynamischem Avalanche bei höheren Spannungen und den möglichen Strominhomogenitäten.

Die aus der obigen Analyse gewonnene Erkenntnis lässt sich in Form von Ansteuerungsbedingungen formulieren. Im folgenden werden vier Bedingungen genannt, die zumindest alternativ zu erfüllen sind.

Gemäss einer ersten Bedingung der Erfindung sind die Mittel zum Ansteuern des Gates so auszulegen, dass die Abschaltverstärkung $I_A/I_{G,peak}$ deutlich kleiner als 3, insbesondere kleiner oder gleich 2 ist. Dabei soll ein Anodenspannungsanstieg von mindestens 1 kV/µs resultiert

Als Folge davon treffen sich Gatestrom $I_G$ und Anodenstrom $I_A$ bevor die Anodenspannung $V_A$ stark angestiegen ist. Der Kathodenstrom $I_K$ wird also viel rascher null als beim Stand der Technik. Die erste Gefahrenzone (Fig. 2: Zeit zwischen $t_1$ und $t_2$) verliert weitgehend ihre Bedeutung. Insbesondere wird dadurch die tödliche zweite Zone (Fig. 2: Zeitpunkt $t_3$) insgesamt vermieden: Der Gatestrom ist nun beträchtlich über dem Tailstrom, ein Schnittpunkt kann sich nicht mehr ergeben.

Um Instabilitätsbereiche insgesamt zu vermeiden, ist die Gateansteuerung so auszubilden, dass ein Anodenspannungsanstieg von mindestens 1 kV/µs resultiert und dass der Kathodenstrom $I_K$ unter Berücksichtigung des Kirchhoff'schen Gesetzes $I_G + I_K = I_A$, kleiner oder gleich null ist während des gesamten Abschaltvorganges. Unter dem Abschaltvorgang wird dabei derjenige Zeitabschnitt verstanden, der beginnt mit dem Erreichen des Schwellenwertes durch den Gatestrom (vgl. Abschaltverstärkung) und endet mit dem Abklingen des Tailstroms. Wenn diese zweite Bedingung erfüllt ist, dann ist es auch die oben formulierte erste.

Eine dritte Bedingung, die primär auf das Vermeiden der zweiten Gefahrenzone abzielt, ist die, dass die Gateansteuerung so auszulegen ist, dass der Gatestram $I_G$ beim Abschalten mindestens doppelt so gross ist wie der auftretende Tailstrom $I_{Tail}$. Die Grösse des Tailstroms $I_{Tail}$ ist unter anderem bestimmt durch die innere Struktur des GTOs. In einem mittleren Spannungsbereich (z.B. zwischen 1000 und 3000 V) ist er grob gesagt proportional zum Spannungsanstieg $dV_A/dt$. Bei einem $dV_A/dt$ von 1 kV beispielsweise ist $I_{Tail}$ etwa halb so gross wie bei $dV_A/dt = 2$ kV.

An dieser Stelle sei angemerkt, dass bis anhin Anstiegsgeschwindigkeiten $dV_A/dt$ von durchwegs weniger als 500 V/µs gewählt wurden.

Zur Realisierung eines HF-GTOs führt schliesslich auch eine Ansteuerung, bei der der Gatestrom $I_G$ eine Anstiegsgeschwindigkeit $dI_G/dt$ hat, die ausreicht, um innerhalb 1 µs einen Gatestrom in der Grösse des maximal abschaltbaren Anodenstroms $I_{A,max}$ aufzubauen.

In der angestrebten Leistungsklasse (Anodenstrom $I_{A,max} > 1$ kA) sollte der Gatestrom $I_G$ also eine Anstiegsgeschwindigkeit $dI_G/dt$ von mindestens 1 kA/µs haben. Dadurch werden die Ladungsträger im GTO-Gate so rasch abgesaugt, dass die Injektion aus den Kathodenemittern unverzüglich unterbunden wird. Das Absaugen wirkt sich dabei auf alle GTO-Zellen gleichzeitig aus. Damit kann keine unerwünschte Stromfokussierung auftreten.

Beim Umsetzen einer oder mehrerer der genannten Bedingungen in eine konkrete Schaltanordnung sind ein paar Ueberlegungen nötig, die im Folgenden erläutert werden.

Ein GTO muss also weit schneller als bisher angesteuert werden. Steuert man einen GTO aber schneller an, so wird sein Abschaltvorgang bereits von Beginn an beschleunigt. Es fällt dann nämlich der langsame Vorgang der Injektionsverminderung (langsames "Abwürgen") aus der Kathode weg, und die Kathoden können schnell abgeschaltet werden. In der Folge fällt der Anodenspannungsanstieg nicht mehr langsam und rund aus, sondern hart und schnell. Dann aber reagiert die Snubberdiode $D_s$ und die parasitäre Induktivität $L_s$ mit noch weit grösserer Ueberspannung, so dass für den GTO per Saldo kein Gewinn herausschaut (er muss nämlich weiterhin Kathodenstrom bis zu einer erheblichen Anodenspannung führen). Man ist also genötigt, die Gatekreisinduktivität bis zur Bedeutungslosigkeit zu verringern (Entwicklung eines neuen, niederinduktiven Gehäuses), oder man muss auch den Snubber ändern.

Der Snubber muss so geändert werden, dass die Spike-Spannung trotz erhöhtem $dI/dt$ eher kleiner als bisher ausfällt. Dies kann man durch Reduktion der parasitären Induktivität $L_s$ allein nicht erreichen, denn immer bleibt das Forward Recovery der Diode $D_s$ im Kreis. Zwar werden für herkömmliche Snubber bereits spezielle Dioden entwickelt (so dass man wieder grössere $L_s$ zulassen und damit den Aufbau vereinfachen kann), doch dürfte auch mit den bestgeeigneten Si-Dioden kein entscheidender Fortschritt zu erzielen sein. Der gute Weg liegt vielmehr darin, wenigstens einen Teil der Snubberkapazität direkt parallel zum GTO zu schalten. Die Kreisinduktivität sinkt dann nämlich so weit (5 - 10 nH), dass der Kondensator bereits merklich Anodenstrom übernehmen kann, bevor die Anodenspannung die 100 V-Grenze passiert hat. Zusammen mit dem vergrösserten Gatestrom (schneller heisst auch geringere Abschaltverstärkung) kann der Kathodenstrom dann rechtzeitig zu null gehen, d.h. bevor weit mehr als 100 V Anodenspannung anliegen. Unter 100 - 200 V aber kann ein GTO wie bereits erwähnt fast jeden beliebigen Strom ohne Zerstörung abschalten.

Ein Teil von $C_s$ sollte also parallel zum GTO geschaltet werden (z.B. 1 µF bei 3 kA würde den Anodenstrom auf ca. 1/2 - 1/5 des On-Wertes drücken, wenn 100 - 200 V erreicht sind. Daraus resultiert aber ein Problem beim Einschalten: Der parallelgeschaltete Kondensator entlädt sich direkt in den GTO, und das, während bei normalem Zünden das Plasma noch sehr geringe Ausmasse hat. Ohne weitere Vorkehrungen würden GTOs dadurch aller Erfahrung nach zerstört (Ueberschreitung des $dI_A/dt$ Grenzwertes). Wenn der GTO nun auch beim Zünden hart (schnell) angesteuert wird, dann kann sein Zerstörung durch die Entladung des Parallelkondensators vermieden werden. GTOs werden nämlich bei verstärktem Einschalten schneller und homogener. Da ferner das $dI_A/dt$ nur für sehr kurze Zeit (nämlich zur Entladung des Parallelkondensators) überschritten wird, ist die zugehörige Energie- und Leistungsdichte verhältnismässig gering (bei 3 kV und 1 µF wären 4.5 J gespeichert, das sind 450 W bei 100 Hz, d. h. weniger als die Hälfte der typischen Ausschaltverluste).

Aus diesen Ueberlegungen heraus werden die nachfolgend beschriebenen Ausführungsbeispiele besonders bevorzugt.

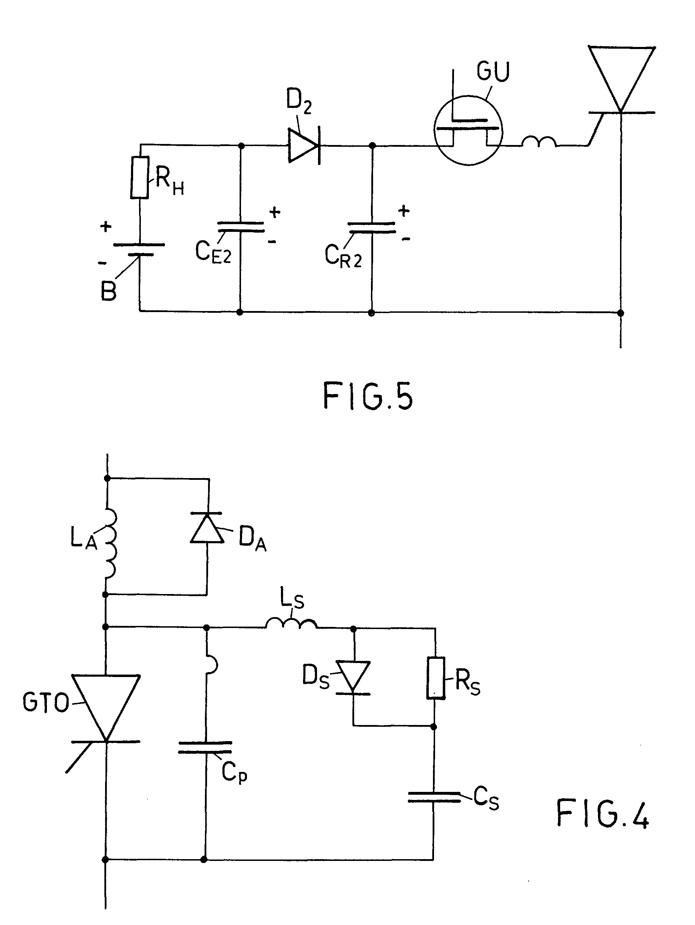

Fig. 3 zeigt schematisch eine Gatebeschaltung zum Abschalten eines GTOs bekannter Bauart. Sie umfasst

- eine relativ geringe Gatekreisinduktivität $L_G$ zwischen Gate-Unit GU und Gateanschluss des GTO-Bauelements,
- eine Kapazität $C_{R1}$ hoher Spannung zwischen Gate-Unit GU und Kathodenanschluss des GTOs und
- parallel zur Kapazität $C_{R1}$ eine Kapazität $C_{E1}$ niederer Spannung und eine zu $C_{E1}$ vorgeschaltete Diode $D_1$ zum Trennen der Kondensatorspannungen.

Die Gatekreisinduktivität ist vorgegeben durch die bei herkömmlichen Gehäusebauarten unvermeidliche Induktivität. Es soll an dieser Stelle nochmals in Erinnerung gerufen werden, dass das Ziel der Erfindung in der Realisierung eines HF-GTOs mit konventionellen Halbleiterbauelementen ist. Der mit der Neukonstruktion von Gehäusen verbundene Aufwand soll vermieden werden.

Bei der in Fig. 3 gezeigten Schaltung handelt es sich um eine für quasiresonanten Betriebsmodus: Der kleine Kondensator $C_{R1}$ mit hoher Spannung (vorzugsweise ≥ 100 V, z.B. $C_{R1}$ = 200 V), der auf den Ausgang der Gate-Unit GU geschaltet ist, liefert zu Beginn einen trotz der vorhandenen Gatekreisinduktivität schnell ansteigenden Strom, der nach dem Entladen von einem Erhaltungskondensator $C_{E1}$ über eine längere Zeit (Dauer des Abschaltvorgangs) aufrechterhalten wird. (Anstelle des einzelnen Kondensators $C_{E1}$ können bei Bedarf auch zwei Kapazitäten unterschiedlicher Spannung vorgesehen sein, z.B. 50 V und 15 V.) Die Kapazität $C_{R1}$ wird (unter Berücksichtigung der tatsächlichen Induktivität im GTO-Gehäuse) so bemessen, dass sie nach Entladung einen Gatestrom aufbaut hat, der dem maximal abschaltbaren Anodenstrom entspricht. Der relativ lang anhaltende Strom aus $C_{E1}$ muss mit einer Spannung angeboten werden, die unterhalb des Avalanche der Gate-Kathodenstrecke (15 - 25 V) liegt.

Es wird also ein Gatestrom angeboten, der genügend hoch und schnell ist, so dass der Kathodenstrom unter allen Umständen kleiner null ist. Mit der länger anhaltenden niedrigen Spannung kann vermieden werden, dass der Gatestrom beim Schalten zusammenbricht und das Bauelement in die kritische zweite Zone (Fig. 2: Zeitpunkt $t_3$) läuft.

Zum Erzeugen eines schnell ansteigenden und stets über dem Tailstrom liegenden Gatestroms eignet sich auch ein an sich bekanntes Pulsformnetzwerk. Wichtig ist weniger die konkrete schaltungstechnische Ausführung, als vielmehr die Erfüllung der angestrebten Funktion.

Ein Grossteil der Gatekreisinduktivität wird bei herkömmlichen Beschaltungen durch das Koaxialkabel zwischen Gate-Unit und äusserem Gateanschluss des GTO-Bauelements erzeugt (Fig. 1: $L_G$). Im GTO-Gehäuse liegen von den typischen 300 nH (d.h. $L_G$ insgesamt) nur gerade etwa 30 nH. Gemäss einer bevorzugten Ausführungsform der Erfindung ist die Gate-Unit deshalb mit einem Flachbandleiter, wie er aus der EP-0,381,849 A1 bekannt ist (z.B. beidseitig metallisiertes Polyimidband), an das Gate des GTO-Bauelements angeschlossen. Auf diese Weise lassen sich Gatekreisinduktivitäten $L_G ≤ 50$ nH verwirklichen, ohne die bestehenden Gehäuse durch neue ersetzen zu müssen. Dies führt zu den erwünschten Anstiegsgeschwindigkeiten $dI_G/dt ≥ 1$ kA/µs. Maximal lassen sich mit diesen einfachen Vorkehrungen etwa 5 kA/µs erreichen.

Ein Vorteil der harten Ansteuerung liegt nicht zuletzt in der kleinen Speicherzeit: Während beim Stand der Technik der Gatestrom so langsam ansteigt, dass zwischen dem Triggern des Gateschalters (MOSFET) und dem Einsetzen des Abschaltvorganges im GTO bis zu 15 µs vergehen, sorgt der steile Anstieg gemäss der Erfindung dafür, dass diese Verzögerung in den Bereich von 1 µs zu liegen kommt. Zusätzlich sind die Schwankungen in der Speicherzeit, die bekanntlich von der jeweiligen Grösse des Anodenstroms abhängt, bei der Erfindung viel geringer: Durch den steilen Gatestromanstieg können sich die Schwankungen nämlich nur noch im Bereich von einigen 100 ns bewegen. Insgesamt wird so der Schaltvorgang besser kontrollierbar.

Die erfindungsgemässe Gatebeschaltung spart auch Energie. Zwar muss ein viel höherer Gatestrom erzeugt werden, dies aber nur über eine sehr kurze Zeit hinweg. Die bislang auch aus energetischen Gründen immer wieder geforderte hohe Abschaltverstärkung verliert somit an Bedeutung. Auch im kleinen $L_G$ wird viel weniger Energie als beim Stand der Technik gespeichert.

Fig. 4 zeigt einen erfindungsgemässen Snubber. Er umfasst

-    eine zum GTO-Bauelement unmittelbar parallelgeschaltete Kapazität $C_p$ (niederinduktiver Kreis) und
-    einen konventionellen Snubber mit Induktivität $L_s$, Diode $D_s$, Kapazität $C_s$ und Widerstand $R_s$.

Die erfindungsgemässe parallele Kapazität $C_p$ ermöglicht dem GTO das sichere Abschalten. Sie ist so zu bemessen, dass der Anodenspannungsanstieg $dV_A/dt$ so begrenzt wird, dass nur noch ein Teil des Laststroms (ca. 1/2 - 1/5) durch den GTO fliesst, wenn die Anodenspannung die 100 V-Marke passiert. Sie soll aber so klein gehalten werden, dass beim Einschalten ihre Entladung in den GTO nicht merklich zu dessen Verlusten beiträgt, um die GTO-Kühlung nicht zu erschweren. Günstige $C_p$-Werte für die oben erwähnte Ansteuerung bemessen sich gemäss folgender Regel:

$$3 \text{ kV}/\mu s \leq \frac{I_A}{C_p} \leq 10 \text{ kV}/\mu s \ (I_A = \text{Anodenstrom}).$$

$C_p$ ist damit um einen Faktor 6 - 20 kleiner als $C_s$ heute (Fig. 1). Entsprechend wird darin weniger Energie gespeichert. Die durch das direkte Entladen von $C_p$ bedingte zusätzliche Belastung bewegt sich in der Grössenordnung von 10% der thermischen Gesamtbelastung des GTOs.

Durch die Zweiteilung des Snubbers kann die restliche Snubberbeschaltung ($C_s$, $D_s$, $R_s$) und/oder ein allfälliger Clamping-Kondensator zum Begrenzen von Spannungsspitzen aufgrund Last- und Streuinduktivitäten weitgehend unabhängig vom GTO-Bauelement dimensioniert werden.

Vorzugsweise setzt man parallel zu $L_A$ (dI/dt-Drossel) eine Diode $D_A$, oder man verwendet Schaltungen wie die bekannte Undelandschaltung, so dass die in $L_A$ gespeicherte Energie nicht auf $C_s$ übertragen wird. Anderenfalls können nämlich unwirtschaftlich hohe Ueberspannungen resultieren. $C_s$ dient also nur noch zur dV/dt-Begrenzung am GTO selbst. Da aufgrund der harten Ansteuerung genügend Gatestrom zur Verfügung steht, wird man in der Regel $C_s$ sogar ganz zu null werden lassen können. Mit anderen Worten: Man kann den konventionellen Teil der Snubberbeschaltung ($L_s$, $C_s$, $D_s$, $R_s$) insgesamt weglassen. Die mit dem Reverse Recovery der Diode $D_s$ verbundenen Probleme, die durch das erfindungsgemässe $C_p$ ohnehin entschärft worden sind, fallen dann insgesamt weg.

Wenn man die Kapazität $C_p$ nicht als einen Teil des Snubbers versteht, sondern dem GTO-Bauelement zuordnet, dann kann man dieses "GTO/$C_p$-Element" als einen Schalter betrachten, der vorteilhafte Eigenschaften und gewisse Ansteuerbedingungen hat und der nach anerkannten Prinzipien beschaltet werden soll (z. B. mit Snubber, Freilauf etc.). Bei gewissen Halbleiterbauelementen bringt die parallele Kapazität $C_p$ nur unwesentliche Vorteile. Entsprechend wird man sich mit der erfindungsgemässen Gateansteuerung zufrieden geben.

Die Erfindung schlägt auch Verbesserungen beim Einschalten des GTOs vor, die vorteilhaft mit der übrigen Beschaltung (siehe oben) zusammenwirken.

Fig. 5 zeigt eine bevorzugte Ausführungsform der Gatebeschaltung für das Einschalten des GTOs. Sie realisiert ein hartes Einschalten: Wie beim Ausschalten (nur mit umgekehrter Polarität) wird an das Gate ein schnell ansteigender, starker Stromstoss angelegt. Die Schaltung ist mit Vorteil ähnlich wie die für das Abschalten benötigte. Auf diese Weise erhält man eine im wesentlichen symmetrische Beschaltung des Gates.

Wenn der Schalter (MOSFET) der Gate-Unit GU geschlossen wird, wird aus einem Kondensator $C_{R2}$ hoher Spannung (vorzugsweise $\geq$ 100 V) ein schnell ansteigender Strom in das Gate des GTOs injiziert. Nach Entladung des relativ kleinen Kondensators $C_{R2}$ hält ein grösserer Kondensator $C_{E2}$ den Zündstrom über die geforderte Zeit aufrecht. $C_{E2}$ hat eine kleine Spannung (typischerweise 15 V) im Vergleich zu $C_{R2}$. Eine Diode $D_2$ trennt den Hochspannungs- vom Niederspannungskondensator $C_{R2}$ resp $C_{E2}$. Der Haltestrom kommt beispielsweise aus der in der Figur angedeuteten Batterie B über den Widerstand $R_H$.

Das verstärkte Einschalten wirkt sich auch positiv auf die Homogenität des Stroms aus. Somit wird auch das Entladen von $C_p$ in den GTO weniger kritisch.

Durch das im Vergleich zum Stand der Technik harte Einschalten dürfte der GTO auch mit höheren $dI_A/dt$ Werten belastbar sein. Damit steht eine Reduktion von $L_A$ in Aussicht (d.h. es wird weniger Energie in $L_A$ gespeichert). Wegen den involvierten Zünd- und Plasmaausbreitungsmechanismen dürfte die Belastbarkeit jedoch von verschiedenen Faktoren abhängen, d.h. sie wird von Element zu Element typengeprüft werden müssen.

Selbstverständlich erlaubt die hier vorgeschlagene Beschaltung auch die Nutzung neuerer feinstrukturierter Halbleiterbauelemente. Dass nämlich bisher mit feinstrukturierten GTOs (FS-GTO) und SIThs keine deutlichen Vorteile erreicht werden konnte, liegt zum wesentlichen Teil auch an der Verletzung der hier beschriebenen Gesetzmässigkeiten. Mit FS-GTOs ist deshalb nun eine deutliche Vergrösserung der Abschaltstromdichten gegenüber herkömmlichen Elementen zu erwarten. Mit SIThs und insbesondere FCThs wird man zudem die Einschaltinhomogenitäten vermeiden können. Infolgedessen kann auf die harte Ansteuerung beim Einschalten und die $dI_A/dt$-Begrenzung verzichtet werden.

Zusammenfassend kann festgestellt werden, dass mit der Erfindung der Weg zur Realisierung eines HF-GTOs aufgezeigt worden ist. Der Beschaltungsaufwand wird wesentlich verkleinert und gleichzeitig die Betriegssicherheit erhöht. Der HF-GTO lässt sich insbesondere mit bereits im Handel erhältlichen Halbleiterbauelementen aufbauen.

**Bezeichnungsliste**

B - Batterie; $C_s$, $C_G$, $C_p$, $C_{R1}$, $C_{R2}$, $C_{E1}$, $C_{E2}$ - Kapazität; $D_s$, $D_1$, $D_2$- Diode; GU - Gate-Unit; $I_A$ - Anodenstrom; $I_G$ - Gatestrom; $I_K$ - Kathodenstrom: $L_A$ - di/dt-Drossel; $L_s$, $L_G$ - Induktivität; $R_s$, $R_H$ - Widerstand; $V_A$ - Anodenspannung.

**Patentansprüche**

1. Schaltungsanordnung für einen HF-GTO hoher Leistung, umfassend ein einrastendes Halbleiterbauelement (GTO) mit einer Anode, einer Kathode und einem Gate, und einer Gate-Unit (GU) zum Erzeugen eines Gatestroms $I_G$ am Gate zum Abschalten des Halbleiterbauelements (GTO), wobei die Gate-Unit niederinduktiv an das Gate des Halbleiterbauelements (GTO) angeschlossen ist, **dadurch gekennzeichnet, dass** eine Schaltung ($C_{E1}$, $C_{R1}$, $D_1$) zwischen der Kathode und der Gate-Unit (GU) angeordnet ist, umfassend

   - eine erste Kapazität $C_{R1}$, die über einen Schalter zwischen Gate und Kathode des GTOs geschaltet ist und die durch Entladen den schnell ansteigenden ersten Gatestrom $I_G$ zum Abschalten des GTOs erzeugt, und
   - eine zweite Kapazität $C_{E1}$, die über eine erste Diode $D_1$ parallel zur ersten Kapazität $C_{R1}$ angeordnet ist und die durch Entladen den Gatestrom $I_G$ nach Auftreten des Tailstromes erzeugt.

2. Schaltungsanordnung nach Anspruch 1, **dadurch gekennzeichnet, dass** die erste Kapazität $C_{R1}$ vor dem Abschalten des GTOs eine Spannung von mindestens 100 V aufweist.

3. Schaltungsanordnung nach Anspruch 1, **dadurch gekennzeichnet, dass** zum Einschalten des GTOs eine dritte Kapazität $C_{R2}$ über einen Schalter zwischen Gate und Kathode des GTOs geschaltet ist und die durch Entladen einen zum Einschalten benötigten zweiten Gatestrom $I_G$ erzeugt.

4. Schaltungsanordnung nach Anspruch 3, **dadurch gekennzeichnet, dass** über eine zweite Diode $D_2$ parallel zu der Kapazität $C_{R2}$ eine weitere Kapazität $C_{E2}$ angeordnet ist, die einen den eingeschalteten Zustand des GTOs aufrechterhaltenden Haltestrom zur Verfügung stellt.

5. Schaltungsanordnung nach Anspruch 4, **dadurch gekennzeichnet, dass** parallel zu der Kapazität $C_{E2}$ eine Spannungsquelle angeordnet ist.

6. Schaltungsanordnung nach einem der Ansprüche 1 bis 5 **dadurch gekennzeichnet, dass** der Schalter niederinduktiv an das Gate des GTOs angekoppelt ist und eine gesamte Gatekreisinduktivität weniger als 50 nH beträgt.

7. Schaltungsanordnung nach Anspruch 3, **dadurch gekennzeichnet, dass** eine Schutzbeschaltung für den GTO vorgesehen ist, welche eine unmittelbar parallel zum GTO zwischen Anode und Kathode geschaltete, induktivitätsarme Kapazität $C_p$ umfasst, die den Anodenspannungsanstieg $dV_A/dt$ mindestens nach Erreichen einer Anodenspannung von $V_A$=400V so begrenzt, dass der Anodenstrom $I_A$ in der Folge kleiner als der Gatestrom $I_G$ wird.

8. Schaltungsanordnung nach Anspruch 7, **dadurch gekennzeichnet, dass** die Kapazität $C_p$ in Bezug auf den Anodenstrom $I_A$ nach folgender Regel bemessen ist:

$$3kV/\mu s \leq I_A/C_p \leq 10kV/\mu s.$$

9. Schaltungsanordnung nach Anspruch 8, **dadurch gekennzeichnet, dass** zweite Mittel ($D_A$; $D_S$, $L_S$, $C_S$, $R_S$) zum Fernhalten der in einer in Serie mit dem Halbleiterbauelement angeordneten, stromanstiegsbegrenzenden Induktivität $L_A$ gespeicherten Energie von der parallelen Kapazität $C_p$ in Form eines Freilaufs ($L_A$) oder eines Snubbers ($D_S$, $L_S$, $C_S$, $R_S$) vorgesehen sind.

**Claims**

1. Switching arrangement for a high-power RF-GTO, comprising a latching-type semiconductor component (GTO) having an anode, a cathode and a gate, and a gate unit (GU) for generating a gate current $I_G$ at the gate for turning off the semiconductor component (GTO), the gate unit being connected with low inductance to the gate of the semiconductor component (GTO), **characterized in that** a circuit ($C_{E1}$, $C_{R1}$, $D_1$) is arranged between the cathode and the gate unit (GU), comprising

   - a first capacitance $C_{R1}$, which is connected via a switch between the gate and cathode of the GTO and which, by discharging, generates the quickly rising first gate current $I_G$ for turning off the GTO, and

- a second capacitance $C_{E1}$, which is arranged via a first diode $D_1$ in parallel with the first capacitance $C_{R1}$ and which, by discharging, generates the gate current $I_G$ after occurrence of the tail current.

2. Circuit arrangement according to Claim 1, **characterized in that** the first capacitance $C_{R1}$ has a voltage of at least 100 V before the GTO is turned off.

3. Circuit arrangement according to Claim 1, **characterized in that**, for turning on the GTO, a third capacitance $C_{R2}$ is connected via a switch between the gate and cathode of the GTO and which, by discharging, generates a second gate current $I_G$, required for switching on.

4. Switching arrangement according to Claim 3, **characterized in that** a further capacitance $C_{E2}$ is arranged via a second diode $D_2$ in parallel with the capacitance $C_{R2}$, which further capacitance provides a holding current maintaining the turned-on state of the GTO.

5. Switching arrangement according to Claim 4, **characterized in that** a voltage source is arranged in parallel with the capacitance $C_{E2}$.

6. Switching arrangement according to one of Claims 1 to 5, **characterized in that** the switch is coupled with low inductance to the gate of the GTO and has a total gate circuit inductance of less than 50 nH.

7. Circuit arrangement according to Claim 3, **characterized in that** a protective circuit for the GTO is provided, which circuit comprises a low-inductance capacitance $C_p$ which is connected directly in parallel with the GTO between the anode and cathode, which capacitance limits the anode voltage rise $dV_A/dt$, at least after an anode voltage of $V_A = 400$ V has been reached, in such a manner that the subsequent anode current $I_A$ becomes less than the gate current $I_G$.

8. Switching arrangement according to Claim 7, **characterized in that** the capacitance $C_p$ is dimensioned with respect to the anode current $I_A$ in accordance with the following rule:

$$3kV/\mu s \leq I_A/C_P \leq 10kV/\mu s.$$

9. Switching arrangement according to Claim 8, **characterized in that** second means ($D_A$; $D_S$, $L_S$, $C_S$, $R_S$) for keeping the energy stored in the current-increase-limiting inductance LA, arranged in series with the semiconductor component, away from the parallel capacitance $C_p$ are provided in the form of a freewheeling circuit ($L_A$) or a snubber ($D_S$, $L_S$, $C_S$, $R_S$).

## Revendications

1. Arrangement de circuit pour un GTO HF de grande puissance, comprenant un composant semiconducteur à verrouillage (GTO) muni d'une anode, d'une cathode et d'une gâchette, et un module de gâchette (GU) destiné à produire un courant de gâchette $I_G$ à la gâchette pour éteindre le composant semiconducteur (GTO), le module de gâchette étant raccordé avec une basse impédance à la gâchette du composant semiconducteur (GTO), **caractérisé en ce qu'**un circuit ($C_{E1}$, $C_{R1}$, $D_1$) est disposé entre la cathode et le module de gâchette (GU) qui comprend

- un premier condensateur $C_{R1}$ qui est branché entre la gâchette et la cathode du GTO par le biais d'un commutateur et qui, en se déchargeant, produit le premier courant de gâchette $I_G$ à montée rapide destiné à éteindre le GTO, et
- un deuxième condensateur $C_{E1}$ qui est branché en parallèle avec le premier condensateur $C_{R1}$ par le biais d'une diode $D_1$ et qui, en se déchargeant, produit le courant de gâchette $I_G$ après apparition du courant de queue.

2. Arrangement de circuit selon la revendication 1, **caractérisé en ce que** le premier condensateur $C_{R1}$ présente une tension minimale de 100 V avant l'extinction du GTO.

3. Arrangement de circuit selon la revendication 1, **caractérisé en ce qu'**un troisième condensateur $C_{R2}$ est branché entre la gâchette et la cathode du GTO pour allumer le GTO et génère, en se déchargeant, un deuxième courant de gâchette $I_G$ nécessaire pour l'allumage.

4. Arrangement de circuit selon la revendication 3, **caractérisé en ce qu'**un condensateur supplémentaire $C_{E2}$ est branché en parallèle au condensateur $C_{R2}$ par le biais d'une diode $D_2$, lequel fournit un courant de maintien qui permet de maintenir l'état passant du GTO.

5. Arrangement de circuit selon la revendication 4, **caractérisé en ce qu'**une source de tension est branchée en parallèle avec le condensateur $C_{E2}$.

6. Arrangement de circuit selon l'une des revendications 1 à 5, **caractérisé en ce que** le commutateur est raccordé à basse impédance à la gâchette du GTO et présente une inductance de circuit de gâchette totale inférieure à 50 nH.

7. Arrangement de circuit selon la revendication 3, **caractérisé en ce qu'**il est prévu un branchement de protection pour le GTO, lequel comprend un condensateur Cp branché directement en parallèle avec le GTO entre l'anode et la cathode et qui limite le taux de montée de la tension d'anode $dV_A/dt$ au moins après avoir atteint une tension d'anode de $V_A$ = 400 V de manière à ce que le courant d'anode $I_A$ devienne ensuite inférieur au courant de gâchette $I_G$.

8. Arrangement de circuit selon la revendication 7, **caractérisé en ce que** le condensateur Cp est dimensionné selon la règle suivante en fonction du courant d'anode $I_A$ :

$$3 \text{ kV/}\mu\text{s} \leq I_A/Cp \leq 10 \text{ kV/}\mu\text{s}.$$

9. Arrangement de circuit selon la revendication 8, **caractérisé en ce qu'**ils sont prévu deuxièmes moyens ($D_A$ ; Ds, Ls, Cs, Rs) sous la forme d'un circuit de roue libre ($L_A$) ou d'un circuit d'amortissement (Ds, Ls, Cs, Rs) pour tenir l'énergie accumulée dans l'inductance $L_A$ de limitation du taux de montée du courant qui est branchée en série avec le composant semiconducteur éloignée du condensateur parallèle Cp.

FIG.1

FIG.3

FIG.2

EP 0 489 945 B1

FIG.5

FIG.4